# EUROPEAN PATENT APPLICATION

(11) **EP 4 804 769 A1**
(43) Date of publication of application: **09.09.2026**
(21) Application number: 24885545.4
(22) Date of filing: 23.10.2024
(51) Int. Cl.: H10H 20/851, H10H 20/853, H10H 20/856

(54) **LIGHT EMITTING DEVICE**

(30) Priority: 30.10.2023 JP 2023185424
(71) Applicant: Panasonic Intellectual Property Management Co., Ltd., Kadoma-shi, Osaka 571-0057 (JP)
(72) Inventor: NAKASHIMA, Noriyasu, Kadoma-shi, Osaka 571-0057 (JP); ABE, Takeshi, Kadoma-shi, Osaka 571-0057 (JP)
(74) Representative: Müller-Boré & Partner Patentanwälte PartG mbB
(86) International application number: PCT/JP2024/037662
(87) International publication number: WO 2025/094772

(57) **Abstract**

Provided is a light emitting device (1), including: a plurality of light emitting elements (10) arranged at a predetermined interval; a first phosphor layer (20) made from phosphor ceramic; and a filling member (30, 30A) that covers side surfaces of the plurality of light emitting elements (10) and is provided between adjacent light emitting elements (10). The first phosphor layer (20) is a single plate-like member that covers light output surfaces of the plurality of light emitting elements (10), and the first phosphor layer (20) is arranged to be in contact with the plurality of light emitting elements (10) and the filling member (30, 30A).

## Description

### TECHNICAL FIELD

The present disclosure relates to a light emitting device.

### BACKGROUND ART

In recent years, light emitting devices combining a light emitting element such as a light emitting diode (LED) or a laser diode (LD) with phosphor have become widely used. Light emitting devices are used as light sources for image display devices such as displays and projectors, as well as for lighting devices.

Patent Literature 1 discloses a light emitting device including a light emitting diode, and a phosphor layer including phosphor. Specifically, the light emitting device includes: a light emitting diode electrically bonded to a circuit board; a housing surrounding the light emitting diode; and a light emitting device component having a sealing resin layer capable of sealing the light emitting diode, and a phosphor layer formed on the surface of the sealing resin layer.

### CITATION LIST

### PATENT LITERATURE

Patent Literature 1: Japanese Unexamined Patent Application Publication 2012-28666

### SUMMARY OF INVENTION

Here, in a light emitting device combining a light emitting element and phosphor, heat emitted from the phosphor causes the temperature of the phosphor layer to rise, which may result in a phenomenon in which emission intensity decreases over time (temperature quenching). Therefore, it is necessary to perform heat dissipation from the phosphor layer in order to control the temperature quenching. However, in Patent Literature 1, a sealing resin layer having low thermal conductivity is present between the phosphor layer and the light emitting diode, resulting in insufficient heat dissipation from the phosphor layer, and thus making it difficult to control temperature quenching of the phosphor.

The present disclosure has been made in consideration of the above issue, which is inherent in the related art. An object of the present disclosure is to provide a light emitting device capable of efficiently performing heat dissipation from a phosphor layer.

In response to the above issues, a light emitting device according to an aspect of the present disclosure includes: a plurality of light emitting elements arranged at a predetermined interval; a first phosphor layer made from phosphor ceramic; and a filling member that covers side surfaces of the plurality of light emitting elements and is provided between adjacent light emitting elements. The first phosphor layer is a single plate-like member that covers light output surfaces of the plurality of light emitting elements, and the first phosphor layer is arranged to be in contact with the plurality of light emitting elements and the filling member.

### BRIEF DESCRIPTION OF DRAWINGS

[Fig. 1A] Fig. 1A is a cross-sectional view of an example of a light emitting device according to a first embodiment.
[Fig. 1B] Fig. 1B is a plan view of the light emitting device according to Fig. 1A.
[Fig. 1C] Fig. 1C is a plan view of the light emitting device of Fig. 1B with a first phosphor layer removed.
[Fig. 2A] Fig. 2A is a cross-sectional view for explaining a heat dissipation path in the light emitting device according to the first embodiment.
[Fig. 2B] Fig. 2B is a plan view for explaining heat dissipation paths in the light emitting device according to the first embodiment.
[Fig. 3A] Fig. 3A is a cross-sectional view of an example of a light emitting device according to a second embodiment.
[Fig. 3B] Fig. 3B is a plan view of the light emitting device according to Fig. 3A.
[Fig. 4] Fig. 4 is a cross-sectional view of another example of the light emitting device according to the second embodiment.
[Fig. 5] Fig. 5 is a cross-sectional view of an example of a light emitting device according to a third embodiment.
[Fig. 6] Fig. 6 is a diagram illustrating a beam profile result for a light emitting device of example 1-1.
[Fig. 7] Fig. 7 is a diagram illustrating a beam profile result for a light emitting device of example 1-2.
[Fig. 8] Fig. 8 is a front view illustrating the overall shape of an analytical model used in CAE analysis of example 2.
[Fig. 9] Fig. 9 is a perspective view of a light emitting module in the analytical model used in the CAE analysis.
[Fig. 10A] Fig. 10A is a plan view of the light emitting module in the analytical model used in the CAE analysis.
[Fig. 10B] Fig. 10B is a front view of the light emitting module in the analytical model used in the CAE analysis.
[Fig. 11] Fig. 11 is a schematic diagram illustrating a light emitting device in the analytical model used in the CAE analysis.
[Fig. 12] Fig. 12 is a plan view for explaining the arrangement of light emitting elements, and a dam material in the light emitting device in the analytical model used in the CAE analysis.
[Fig. 13] Fig. 13 is a plan views for explaining the arrangement of a phosphor layer, a filling member, and a dam material in the light emitting device in the analytical model used in the CAE analysis.
[Fig. 14] Fig. 14 is a table listing structures of light emitting devices of examples 2-1 to 2-3 and comparative examples 2-1 to 2-3, and results of the CAE analysis.
[Fig. 15] Fig. 15 includes contour diagrams each illustrating a temperature distribution on the surface of the first phosphor layer on a light output surface side in the CAE analysis for the light emitting devices of example 2-1, comparative example 2-1, and comparative example 2-3.
[Fig. 16] Fig. 16 is a graph illustrating the relationship between the diagonal distance of the first phosphor layer and the surface temperature of the first phosphor layer along dotted lines in Fig. 15.
[Fig. 17] Fig. 17 includes contour diagrams each illustrating a temperature distribution of the surface of the first phosphor layer on the light output surface side, and a temperature distribution of the surface of a second phosphor layer on the light output surface side, in the CAE analysis for light emitting devices of example 2-2, example 2-3, and comparative example 2-2.
[Fig. 18] Fig. 18 is a graph illustrating the relationship between the diagonal distance of the first phosphor layer and the surface temperature of the first phosphor layer along dotted lines in Fig. 17.
[Fig. 19] Fig. 19 is a graph illustrating the relationship between the diagonal distance of the second phosphor layer and the surface temperature of the second phosphor layer along dotted lines in Fig. 17.

### DESCRIPTION OF EMBODIMENTS

Referring to the drawings, a description is given below of a light emitting device according to the present embodiment. Note that dimensional ratios in the drawings are exaggerated for convenience of the description and are sometimes different from actual ratios.

### [First embodiment]

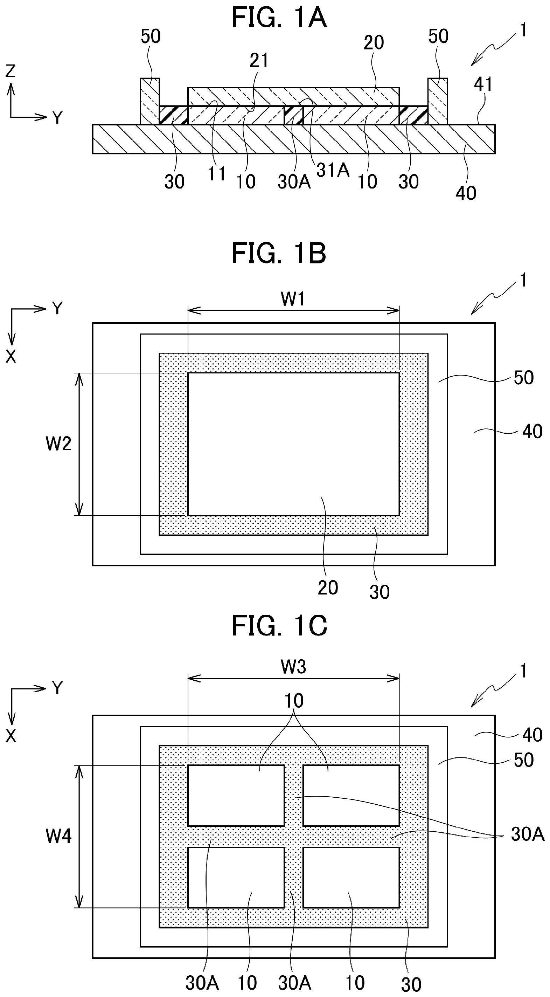

As illustrated in Figs. 1A and 1B, a light emitting device 1 according to the present embodiment includes multiple light emitting elements 10, a first phosphor layer 20 made from a phosphor ceramic, and a filling member 30 covering side surfaces of the multiple light emitting elements 10.

The multiple light emitting elements 10 are mounted on a main surface 41 of a substrate 40 having a plate shape. The substrate 40 is provided with metal wiring for supplying electric power to the light emitting elements 10, and electrodes for supplying electric power to the light emitting elements 10 from an external device. Although the material configuring the substrate 40 is not particularly limited, the substrate 40 may be a ceramic substrate, a resin substrate, a glass substrate, or a metal base substrate where an electric insulating film is coated on a metal plate.

A white substrate having a high light reflectance may be used as the substrate 40. By using the white substrate, light emitted from the light emitting elements 10 can be reflected on the surface of the substrate 40, and thus extraction efficiency of light can be enhanced. As the substrate 40, a white ceramic substrate made from alumina can be used. Note that the shape of the substrate 40 when viewed in plan is not particularly limited, but may be rectangular, circular, or polygonal as illustrated in Fig. 1B.

The multiple light emitting elements 10 may be light emitting diodes (LED) or laser diodes (LD). In the present embodiment, as illustrated in Fig. 1C, four light emitting elements 10 are mounted on the substrate 40 and arranged in two rows in an X-axis direction and two rows in a Y-axis direction. Note that adjacent light emitting elements 10 are spaced apart from each other and arranged at a predetermined interval. As described below, the filling member 30 is filled between adjacent light emitting elements 10.

Each of the light emitting elements 10 has an upper surface 11 that is a light output surface for emitting excitation light. The multiple light emitting elements 10 are electrically connected to turn on and off collectively. Specifically, adjacent light emitting elements 10 are connected in a chip-to-chip manner via a bonding wire for power supply. Note that the number of the light emitting elements 10 is four in Fig. 1C, but is not particularly limited as long as it is greater than 1.

Although the wavelength of excitation light emitted from the light emitting elements 10 is not particularly limited, the peak wavelength of excitation light can be 430 nm or more and 460 nm or less, and can be 445 nm or more and 460 nm or less. When the peak wavelength of excitation light is 430 nm or more, color rendering properties of light emitted from the light emitting device 1 can be enhanced. In addition, when the peak wavelength of excitation light is 460 nm or less, light emission efficiency of the light emitting device 1 can be improved. Note that excitation light emitted from the light emitting elements 10 is not limited to blue light, but may be ultraviolet light, green light, or red light. The multiple light emitting elements 10 may be a combination of a light emitting element emitting ultraviolet light or green light, and a light emitting element emitting blue light, or a combination of a light emitting element emitting blue light, and a light emitting element emitting red light.

The first phosphor layer 20 is made from a phosphor ceramic obtained by sintering phosphor. Since the phosphor ceramic is configured only with an inorganic material excellent in thermal conductivity, it is possible to dissipate heat emitted from the phosphor in the phosphor ceramic, control temperature quenching of the phosphor, and achieve high-output light emission.

Here, for example, the thermal conductivity of a phosphor ceramic obtained by sintering a (Ga,Sc)₂O₃:Cr³⁺ phosphor is about 8.6 W/m·K, and the thermal conductivity of a phosphor ceramic obtained by sintering a Gd₃Ga₂(GaO₄)₃:Cr³⁺ phosphor is about 6.5 W/m·K. The thermal conductivity of a phosphor ceramic obtained by sintering a Y₃Al₅O₁₂:Ce³⁺ phosphor is about 10 W/m·K. In contrast, the thermal conductivity of a wavelength conversion member in which phosphor particles are dispersed in a translucent material such as silicone resin is about 0.2 W/m·K. As described above, since the thermal conductivity of phosphor ceramics is better than that of the wavelength conversion member described above, heat emitted from the phosphors can be dissipated efficiently.

As the phosphor included in the first phosphor layer 20, an inorganic phosphor which absorbs excitation light emitted from the light emitting elements 10 and emits fluorescence with a wavelength longer than that of the excitation light can be used. As the phosphor, at least one of blue phosphor, green phosphor, yellow phosphor, or red phosphor can be used.

The blue phosphor has an emission peak in a wavelength range from 470 nm to 500 nm, the green phosphor has an emission peak in a wavelength range from 500 nm to 540 nm, and the yellow phosphor has an emission peak in a wavelength range from 545 nm to 595 nm. Examples of the blue phosphor include BaMgAl₁₀O₁₇:Eu²⁺, CaMgSi₂O₆:Eu²⁺, Ba₃MgSi₂O₈:Eu²⁺ and Sr₁₀(PO₄)₆Cl₂:Eu²⁺. Examples of the green phosphor include (Ba,Sr)₂SiO₄:Eu²⁺, Ca₈Mg(SiO₄)₄Cl₂:Eu²⁺, and Ca₈Mg(SiO₄)₄Cl₂:Eu²⁺,Mn²⁺. Examples of the yellow phosphor include (Sr,Ba)₂SiO₄:Eu²⁺, (Y,Gd)₃Al₅O₁₂:Ce³⁺, and Ca-α-SiAlON:Eu²⁺.

The red phosphor is excited by light emitted from the light emitting elements 10, or at least one of the green phosphor or the yellow phosphor, and emits red light. The red phosphor has an emission peak in a wavelength range from 600 nm to 650 nm. Examples of the red phosphor include Sr₂Si₅N₈:Eu²⁺, CaAlSiN₃:Eu²⁺(CASN), SrAlSi₄N₇:Eu²⁺, CaS:Eu²⁺, La₂O₂S:Eu³⁺, and Y₃Mg₂(AlO₄)(SiO₄) ₂:Ce³⁺.

The phosphor included in the first phosphor layer 20 may be a near-infrared phosphor. As the near-infrared phosphor, for example, an inorganic phosphor having a fluorescence peak in a wavelength range from 750 nm or more to less than 1,500 nm, particularly in a wavelength range from 780 nm or more to less than 900 nm may be used. Representative examples of the near-infrared phosphor include phosphor activated by transition metal ions, and phosphor activated by rare earth ions. Specifically, the near-infrared phosphor may be at least one of a Cr³⁺ activated phosphor or a rare earth activated phosphor. The rare earth activated phosphor can be phosphor activated by at least one selected from the group consisting of Tm³⁺, Er³⁺, Nd³⁺, and Yb³⁺.

In the near-infrared phosphor, a preferable fluorescent ion is Cr³⁺. By using Cr³⁺ as the fluorescent ion, it becomes easy to obtain a near-infrared phosphor that absorbs blue light and converts it into a near-infrared light component. In addition, it also becomes easy to change a light absorption peak wavelength and/or a fluorescence peak wavelength depending on the type of host, which is advantageous in changing an excitation spectrum shape and a fluorescence spectrum shape.

The near-infrared phosphor is preferably phosphor made from a metal complex oxide activated with Cr³⁺. Specifically, the near-infrared phosphor is preferably phosphor using, as a host, at least one selected from the group consisting of borate, phosphate, silicate, aluminate, gallium, germanate, tungstate, and metal oxide, and activated with Cr³⁺. Such a near-infrared phosphor can be at least one selected from the group consisting of CeSc₃(BO₃)₄:Cr³⁺, (La,Y,Sc)₄(BO₃)₄:Cr³⁺, LaSc₃(BO₃)₄:Cr³⁺, ScBO₃:Cr³⁺, KInP₂O₇:Cr³⁺, Sr₃InP₃O₁₂:Cr³⁺, Sr₉In(PO₄)₇:Cr³⁺, NaScSi₂O₆:Cr³⁺, Mg₂Al₄Si₅O₁₈:Cr³⁺, La₃(Ga,Gd)₅GeO₁₄:Cr³⁺, La₃(Ga,Al)₅SiO₁₄:Cr³⁺, LaMgGa₁₁O₁₉:Cr³⁺, Mg₃Ga₂GeO₈:Cr³⁺, Li(In,Sc)Ge₂O₆:Cr³⁺, Zn₃(Ga,Al)Ge₂O₁₀:Cr³⁺, LiMg₂InGe₂O₈:Cr³⁺, NaCa₂GaGe₅O₁₄:Cr³⁺, NaGdMgWO₆:Cr³⁺, (Ga,Sc)₂O₃:Cr³⁺, LaLuO₃:Cr³⁺, Ba₃Sc₄O₉:Cr³⁺, Zn₂SnO₄:Cr³⁺, LiIn₂SbO₆:Cr³⁺, and LiSrAlF₆:Cr³⁺.

The near-infrared phosphor is preferably phosphor having a garnet-type crystal structure, which has a proven track record. Phosphor having a garnet-type crystal structure and activated by Cr³⁺ is represented by a general formula RE₃B'₂(AlO₄)₃:Cr³⁺, or RE₃B'₂(GaO₄)₃:Cr³⁺, for example. Note that RE is a rare earth element, and B' is at least one element selected from Al, Ga, or Sc.

The near-infrared phosphor is preferably at least one of a rare earth aluminum garnet phosphor or a rare earth gallium garnet phosphor. Specifically, the near-infrared phosphor is preferably at least one selected from the group consisting of Y₃Al₂(AlO₄)₃:Cr³⁺, La₃Al₂(AlO₄)₃:Cr³⁺, Gd₃Al₂(AlO₄)₃:Cr³⁺, Y₃Ga₂(AlO₄)₃:Cr³⁺, La₃Ga₂(AlO₄)₃:Cr³⁺, Gd₃Ga₂(AlO₄)₃:Cr³⁺, Y₃Sc₂(AlO₄)₃:Cr³⁺, La₃Sc₂(AlO₄)₃:Cr³⁺, Gd₃Sc₂(AlO₄)₃:Cr³⁺, Y₃Ga₂(GaO₄)₃:Cr³⁺, La₃Ga₂(GaO₄)₃:Cr³⁺, Gd₃Ga₂(GaO₄)₃:Cr³⁺, Y₃Sc₂(GaO₄)₃:Cr³⁺, La₃Sc₂(GaO₄)₃:Cr³⁺, and Gd₃Sc₂(GaO₄)₃:Cr³⁺

As illustrated in Figs. 1A and 1C, the filling member 30 is formed on the main surface 41 of the substrate 40 to cover the periphery of the multiple light emitting elements 10. Specifically, when seen in plan view, the filling member 30 is arranged to contact the periphery of each of the light emitting elements 10 and to cover the entire periphery of the light emitting elements 10. Further, the filling member 30 is provided to fill the gap between adjacent light emitting elements 10.

As long as the filling member 30 is made from a material having thermal conductivity, the material is not particularly limited. The filling member 30 preferably includes a reflective material that reflects light. By including a reflective material, the filling member 30 reflects excitation light emitted from the light emitting elements 10 and fluorescence emitted from the phosphor, and thus light emission efficiency of the light emitting device 1 can be enhanced.

As the filling member 30, for example, a curable white silicone resin can be used. The curable white silicone resin is a resin obtained by dispersing a white pigment in a silicone resin. As the white pigment, at least one selected from the group consisting of titanium dioxide, alumina, a rare earth oxide such as yttrium oxide, zinc sulfate, zinc oxide, and magnesium oxide can be used. The curable white silicone resin may include an inorganic filler in order to enhance the strength and thermal conductivity of the cured product. As the inorganic filler, at least one selected from the group consisting of fused silica, crystalline silica, alumina, silicon nitride, aluminum nitride, boron nitride, glass fiber, and antimony trioxide can be used.

As illustrated in Figs. 1A to 1C, a dam material 50 used as side walls is provided on the outer periphery of the filling member 30 provided around the multiple light emitting elements 10. The dam material 50 is erected from the main surface 41 of the substrate 40 in a Z-axis direction, and is formed in a rectangular shape in plan view to cover the entire outer periphery of the filling member 30. By providing the dam material 50 on the entire outer periphery of the filling member 30, the filling member 30 can be stably held inside the dam material 50. Note that as illustrated in Fig. 1A, the height of the dam material 50 in the Z-axis direction can be higher than that of the layered body of the filling member 30, the light emitting elements 10, and the first phosphor layer 20.

The material configuring the dam material 50 is not particularly limited, and can be at least one selected from the group consisting of metal, resin, and ceramic. Further, since the dam material 50 preferably has light reflectivity, it is more preferably made from a material having light reflectivity.

In the light emitting device 1, the first phosphor layer 20 is layered on the upper surfaces 11 of the multiple light emitting elements 10, and is a single plate-like member covering the light output surfaces of the multiple light emitting elements 10. That is, as illustrated in Fig. 1B, the first phosphor layer 20 covers the upper surface of a filling member 30A located between adjacent light emitting elements 10 in addition to the light output surfaces of the four light emitting elements 10. The first phosphor layer 20 may be directly layered on the upper surface 11 of the multiple light emitting elements 10 or may be layered via an adhesive layer. The adhesive layer for bonding the first phosphor layer 20 to the light emitting elements 10 is not particularly limited, but, for example, at least one of an inorganic adhesive or an organic adhesive, each having light transparency, may be used.

The first phosphor layer 20 is in contact with the upper surfaces 11 of the multiple light emitting elements 10, and an upper surface 31A of the filling member 30A located between adjacent light emitting elements 10. That is, a lower surface 21 of the first phosphor layer 20 may be in direct contact with the upper surfaces 11 of the multiple light emitting elements 10, and the upper surface 31A of the filling member 30A. When the first phosphor layer 20 is bonded to the multiple light emitting elements 10 via an adhesive layer, the first phosphor layer 20 may be in contact with the upper surfaces 11 of the multiple light emitting elements 10, and the upper surface 31A of the filling member 30A located between adjacent light emitting elements 10 via the adhesive layer. Since the first phosphor layer 20 is in contact with the upper surfaces 11 of the multiple light emitting elements 10, and the upper surface 31A of the filling member 30A, heat generated in the first phosphor layer 20 can be conducted to the light emitting elements 10 and the filling member 30A and dissipated, as will be described below.

In the light emitting device 1, when the light output surface side of the multiple light emitting elements 10 is seen in plan view, it is preferable that the outer dimensions of the first phosphor layer 20 be substantially equal to the outer dimensions of the multiple light emitting elements 10. Specifically, as illustrated in Figs. 1B and 1C, it is preferable that an outer dimension W1 of the first phosphor layer 20 in the Y-axis direction be substantially equal to an outer dimension W3 of two light emitting elements 10 including the filling member 30A therebetween. Similarly, it is preferable that an outer dimension W2 of the first phosphor layer 20 in the X-axis direction be substantially equal to an outer dimension W4 of two light emitting elements 10 including the filling member 30A therebetween. By making the outer dimensions of the first phosphor layer 20 substantially equal to the outer dimensions of the multiple light emitting elements 10, the area of the light emitting surface of the light emitting device 1 can be reduced. Thus, output light emitted from the light emitting device 1 becomes less likely to diffuse, and thus the output light easily enters into a lens provided in the vicinity of the light emitting device 1. As a result, the lens provided in the vicinity of the light emitting device 1 can be made compact. Furthermore, through reduction in size of the lens, a housing for holding the lens and the light emitting device 1 therein can also be made compact.

Note that in this description, "the outer dimensions of the first phosphor layer 20 is substantially equal to the outer dimensions of the multiple light emitting elements 10" means that the difference between the outer dimensions of the multiple light emitting elements 10 and the outer dimensions of the first phosphor layer 20 is ±10% or less. Specifically, it means that the difference between the outer dimension W1 of the first phosphor layer 20 and the outer dimension W3 of the light emitting elements 10 is ±10%, and the difference between the outer dimension W2 of the first phosphor layer 20 and the outer dimension W4 of the light emitting elements 10 is ±10%. It is preferable that the difference between the outer dimensions of the multiple light emitting elements 10 and the outer dimensions of the first phosphor layer 20 be ±5% or less.

The action of the light emitting device 1 according to the present embodiment, which has the above configuration, will be described. In the light emitting device 1 according to the present embodiment, when power is applied to the light emitting elements 10, excitation light (primary light) is emitted upward from the light emitting elements 10. The emitted excitation light passes through the first phosphor layer 20, and at this time, part of the excitation light is absorbed by fluorescent ions of phosphor included in the first phosphor layer 20. The absorbed excitation energy is then converted into fluorescence through electronic energy transition of the fluorescent ions, and the fluorescence is emitted upward from the phosphor.

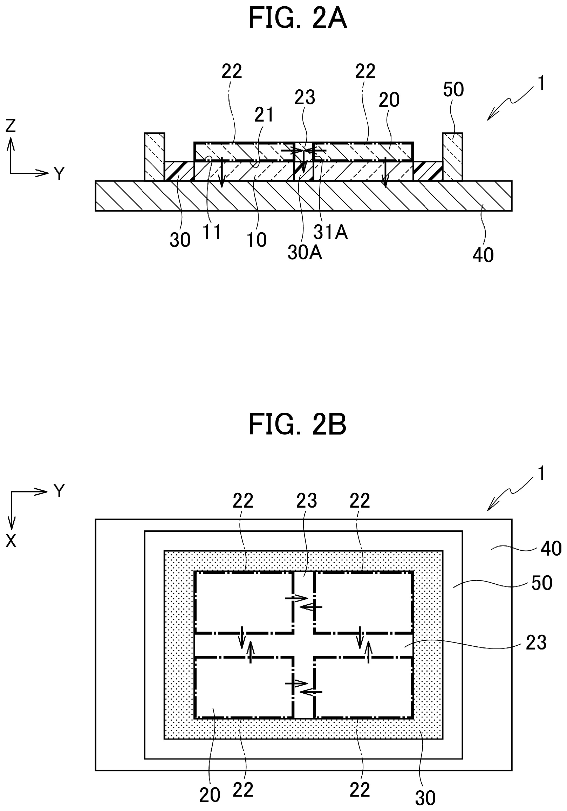

Here, when the excitation light is absorbed and wavelength-converted into fluorescence, the phosphor in the first phosphor layer 20 generates heat. However, phosphor that mainly generates heat is in a region mainly irradiated with the excitation light. That is, the phosphor that mainly generates heat is in regions 22 surrounded by chain lines in Figs. 2A and 2B, specifically, phosphor located directly above the light emitting elements 10. On the other hand, phosphor in the first phosphor layer 20, which is not present directly above the light emitting elements 10, that is, phosphor in a region 23 not surrounded by the chain lines in Figs. 2A and 2B, generates little or very little heat because the irradiation amount of the excitation light is small. Thus, as indicated by arrows in Figs. 2A and 2B, heat conduction occurs from the regions 22 having a large amount of heat generation toward the region 23 having a small amount of heat generation.

The filling member 30A is located below the region 23 having a small amount of heat generation, and the upper surface 31A of the filling member 30A is in contact with the region 23. Thus, the heat conducted to the region 23 is conducted from the region 23 to the filling member 30A, and the heat conducted to the filling member 30A is conducted from the filling member 30A to the substrate 40.

Furthermore, as described above, the first phosphor layer 20 is in contact with the upper surfaces 11 of the multiple light emitting elements 10. Thus, as indicated by arrows in Fig. 2A, heat generated in the regions 22 of the first phosphor layer 20 is conducted from the first phosphor layer 20 to the light emitting elements 10 below, and the heat conducted to the light emitting elements 10 is conducted from the light emitting elements 10 to the substrate 40. Note that the heat conducted to the substrate 40 is dissipated to the outside of the substrate 40.

As described above, in the light emitting device 1 according to the present embodiment, heat generated in the regions 22 of the first phosphor layer 20 is conducted to the region 23 having a relatively low temperature, is further conducted from the region 23 to the filling member 30A, and then is conducted to the substrate 40. At the same time, heat generated in the regions 22 of the first phosphor layer 20 is conducted to the light emitting elements 10, and is further conducted from the light emitting elements 10 to the substrate 40. Thus, since heat dissipation in the regions 22 of the first phosphor layer 20 is efficiently performed, it becomes possible to control temperature quenching of the phosphor included in the regions 22.

Here, if the filling member 30A positioned between adjacent light emitting elements 10 is not provided, an air layer is present between the adjacent light emitting elements 10. Since the air layer has low thermal conductivity, it becomes difficult to dissipate heat conducted to the region 23. However, in the light emitting device 1, since the filling member 30A is provided, heat in the region 23 can be conducted to the substrate 40 through the filling member 30A.

Further, if the light emitting elements 10 and the first phosphor layer 20 are not in contact with each other, and a gap is present, excitation light emitted from the light emitting elements 10 spreads, and the whole of the first phosphor layer 20 is irradiated with the excitation light. As a result, heat is generated in the whole of the first phosphor layer 20, and it becomes difficult for the region 23 to have a relatively low temperature, and there is a possibility that heat dissipation from the first phosphor layer 20 is not sufficiently performed. Thus, in order for the region 23 to have a relatively low temperature, the first phosphor layer 20 needs to be in contact with the multiple light emitting elements 10.

In the light emitting device 1 illustrated in Fig. 1A, the height of the filling member 30 covering the entire periphery of the light emitting elements 10 is substantially the same as the height of the multiple light emitting elements 10. Thus, side surfaces of the first phosphor layer 20 are not in contact with the filling member 30. However, the present embodiment is not limited to such a configuration. For example, the height of the filling member 30 may be made substantially the same as the height of a layered body of the light emitting elements 10 and the first phosphor layer 20, and the side surfaces of the first phosphor layer 20 may be in contact with the filling member 30. Since the side surfaces of the first phosphor layer 20 are covered with the filling member 30 in this manner, heat generated in the first phosphor layer 20 can be conducted to the filling member 30 and dissipated. Thus, heat dissipation of the first phosphor layer 20 can be further enhanced.

Further, in the light emitting device 1, when the light output surface side of the multiple light emitting elements 10 is seen in plan view, the outer dimensions of the first phosphor layer 20 is substantially the same as the outer dimensions of the multiple light emitting elements 10. Since output light emitted from the light emitting device 1 becomes less likely to diffuse, the output light easily enters into a lens provided near the light emitting device 1, and the lens can be made compact.

### [Second embodiment]

Next, a light emitting device according to a second embodiment will be described in detail. Note that the same components as those of the first embodiment are denoted by the same reference numerals, and duplicate descriptions thereof will be omitted.

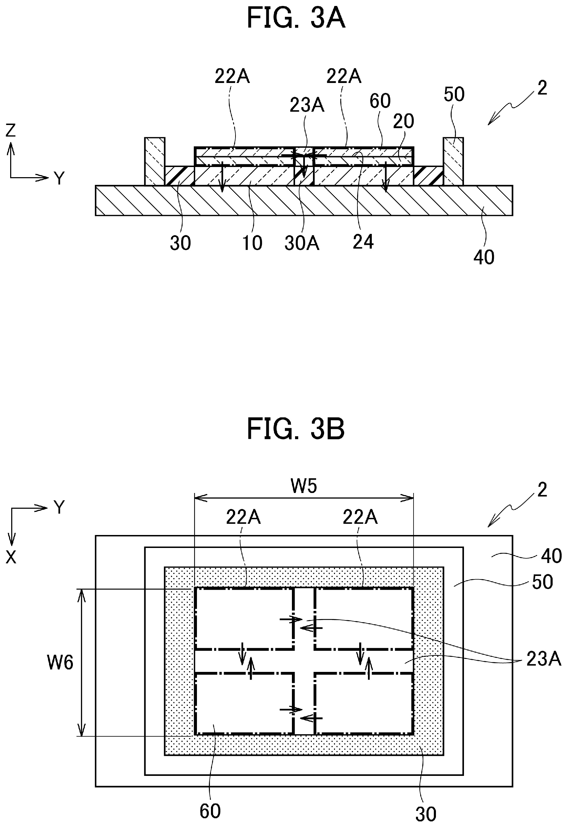

As illustrated in Figs. 3A and 3B, a light emitting device 2 according to the present embodiment includes the multiple light emitting elements 10 arranged at a predetermined interval, the first phosphor layer 20, and the filling member 30.

Similar to the first embodiment, the multiple light emitting elements 10 are mounted on the substrate 40 having a flat shape, and are arranged in two rows in the X-axis direction and two rows in the Y-axis direction. Adjacent light emitting elements 10 are spaced apart from each other and are arranged at a predetermined interval.

The first phosphor layer 20 is made from a phosphor ceramic obtained by sintering phosphor, and is a single plate-like member that covers the light output surfaces of the multiple light emitting elements 10. The filling member 30 is arranged to contact the periphery of each of the light emitting elements 10 and to cover the entire periphery of the light emitting elements 10. The filling member 30 is provided to fill a gap between adjacent light emitting elements 10. Note that the dam material 50 serving as side walls is provided on the outer periphery of the filling member 30 provided around the multiple light emitting elements 10.

The first phosphor layer 20 covers the upper surface of the filling member 30A located between adjacent light emitting elements 10 in addition to the light output surfaces of the four light emitting elements 10. The first phosphor layer 20 may be directly layered on the upper surface 11 of the multiple light emitting elements 10 or may be layered via an adhesive layer.

Here, the light emitting device 2 according to the present embodiment further includes a second phosphor layer 60 layered on the first phosphor layer 20. As described in the first embodiment, in the light emitting device 2, the heat dissipation of the first phosphor layer 20 is improved. Thus, even if the second phosphor layer 60 serving as a heat source is layered on the first phosphor layer 20, temperature rise of the first phosphor layer 20 can be controlled. By providing the second phosphor layer 60 in addition to the first phosphor layer 20, it is possible to obtain a light emitting device capable of emitting fluorescence of multiple wavelengths.

The second phosphor layer 60 may be made from a phosphor ceramic obtained by sintering phosphor, or may be a wavelength conversion member in which phosphor particles are dispersed in a translucent material such as silicone resin. However, it is preferable that the second phosphor layer 60 be made from a phosphor ceramic obtained by sintering phosphor. This makes it possible to efficiently dissipate heat emitted from the phosphor in the second phosphor layer 60 and control temperature quenching of the phosphor.

Although the phosphor included in the second phosphor layer 60 is not particularly limited, at least one of blue phosphor, green phosphor, yellow phosphor, red phosphor, or near-infrared phosphor can be used. Note that the above-mentioned blue phosphor, green phosphor, yellow phosphor, red phosphor, and near-infrared phosphor can be used.

In the light emitting device 2, the second phosphor layer 60 is layered on an upper surface 24 of the first phosphor layer 20, and is a single plate-like member covering the upper surface 24 of the first phosphor layer 20. The second phosphor layer 60 may be directly layered on the upper surface 24 of the first phosphor layer 20 or may be layered via an adhesive layer. The adhesive layer for bonding the first phosphor layer 20 and the second phosphor layer 60 is not particularly limited, but, for example, at least one of an inorganic adhesive or an organic adhesive, each having light transparency, may be used.

In the light emitting device 2, when the light output surface side of the multiple light emitting elements 10 is seen in plan view, it is preferable that the outer dimensions of the second phosphor layer 60 be substantially equal to the outer dimensions of the first phosphor layer 20. Specifically, as illustrated in Fig. 3B, it is preferable that the outer dimension W1 of the first phosphor layer 20 in the Y-axis direction be substantially equal to an outer dimension W5 of the second phosphor layer 60. Similarly, it is preferable that the outer dimension W2 of the first phosphor layer 20 in the X-axis direction be substantially equal to an outer dimension W6 of the second phosphor layer 60. By making the outer dimensions of the first phosphor layer 20 substantially equal to the outer dimensions of the second phosphor layer 60, the area of the light emitting surface of the light emitting device 2 can be reduced. Thus, output light emitted from the light emitting device 2 does not diffuse easily, and thus the output light easily enters into a lens provided in the vicinity of the light emitting device 2. As a result, the lens provided in the vicinity of the light emitting device 2 can be made compact. Furthermore, through reduction in size of the lens, a housing for holding the lens and the light emitting device 2 therein can also be made compact.

Note that in this description, "the outer dimensions of the second phosphor layer 60 is substantially equal to the outer dimensions of the first phosphor layer 20" means that the difference between the outer dimensions of the first phosphor layer 20 and the outer dimensions of the second phosphor layer 60 is ±10% or less. Specifically, it means that the difference between the outer dimension W5 of the second phosphor layer 60 and the outer dimension W1 of the first phosphor layer 20 is ±10%, and the difference between the outer dimension W6 of the second phosphor layer 60 and the outer dimension W2 of the first phosphor layer 20 is ±10%. It is preferable that the difference between the outer dimensions of the first phosphor layer 20 and the outer dimensions of the second phosphor layer 60 be ±5% or less.

The action of the light emitting device 2 according to the present embodiment, which has the above configuration, will be described. In the light emitting device 2 according to the present embodiment, when power is applied to the light emitting elements 10, excitation light (primary light) is emitted upward from the light emitting elements 10. The emitted excitation light passes through the first phosphor layer 20 and the second phosphor layer 60, and at this time, part of the excitation light is absorbed by fluorescent ions of phosphor included in the first phosphor layer 20. Similarly, part of the excitation light is absorbed by fluorescent ions of phosphor included in the second phosphor layer 60. The absorbed excitation energy is then converted into fluorescence through electronic energy transition of the fluorescent ions, and the fluorescence is emitted upward from the phosphor. Note that the light emitting device 2 may have a configuration where the phosphor in the second phosphor layer 60 absorbs fluorescence emitted from the phosphor in the first phosphor layer 20, and emits fluorescence having a longer wavelength.

Here, when the excitation light is absorbed and wavelength-converted into fluorescence, phosphor in the first phosphor layer 20 and the second phosphor layer 60 generates heat. However, phosphor that mainly generates heat is in a region mainly irradiated with the excitation light. That is, the phosphor that mainly generates heat is in regions 22A surrounded by chain lines in Figs. 3A and 3B, specifically, phosphor located directly above the light emitting elements 10. On the other hand, phosphor in the first phosphor layer 20 and the second phosphor layer 60, which is not present directly above the light emitting elements 10, that is, phosphor in a region 23A not surrounded by the chain lines in Figs. 3A and 3B, generates little or very little heat because the irradiation amount of the excitation light is small. Thus, as indicated by arrows in Figs. 3A and 3B, heat conduction occurs from the regions 22A having a large amount of heat generation toward the region 23A having a small amount of heat generation.

The filling member 30A is located below the region 23A having a small amount of heat generation, and the upper surface 31A of the filling member 30A is in contact with the region 23A. Thus, the heat conducted to the region 23A is conducted from the region 23A to the filling member 30A, and the heat conducted to the filling member 30A is conducted from the filling member 30A to the substrate 40.

Furthermore, as described above, the first phosphor layer 20 is in contact with the upper surfaces 11 of the multiple light emitting elements 10. Thus, as indicated by arrows in Fig. 3A, heat generated in the regions 22A of the first phosphor layer 20 is conducted from the first phosphor layer 20 to the light emitting elements 10 below, and the heat conducted to the light emitting elements 10 is conducted from the light emitting elements 10 to the substrate 40. Note that the heat conducted to the substrate 40 is dissipated to the outside of the substrate 40.

As described above, in the light emitting device 2 according to the present embodiment, heat generated in the regions 22A of the first phosphor layer 20 and the second phosphor layer 60 is conducted to the region 23A having a relatively low temperature, is further conducted from the region 23A to the filling member 30A, and then is conducted to the substrate 40. At the same time, heat generated in the regions 22A of the first phosphor layer 20 is conducted to the light emitting elements 10, and is further conducted from the light emitting elements 10 to the substrate 40. Thus, since heat dissipation in the regions 22A of the first phosphor layer 20 and the second phosphor layer 60 is efficiently performed, it becomes possible to control temperature quenching of the phosphor included in the regions 22A.

Here, in the light emitting device 2 illustrated in Fig. 3, the height of the filling member 30 covering the entire periphery of the light emitting elements 10 is substantially the same as the height of the multiple light emitting elements 10. Thus, side surfaces of the first phosphor layer 20 and side surfaces of the second phosphor layer 60 are not in contact with the filling member 30. However, the present embodiment is not limited to such a configuration.

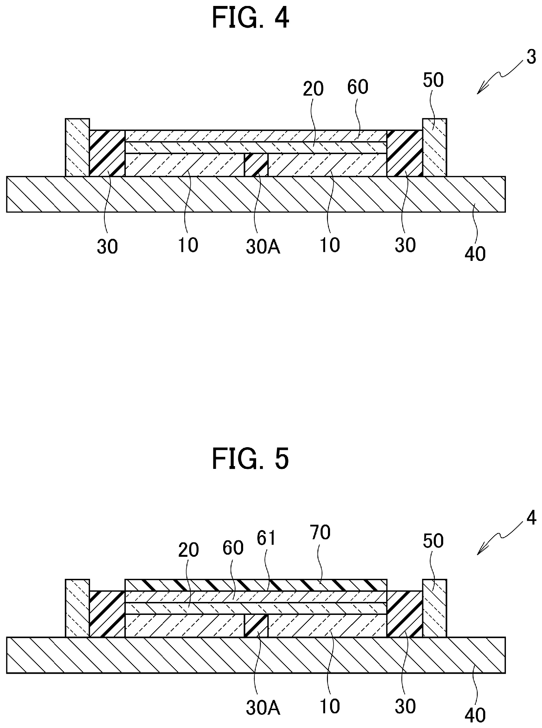

As in a light emitting device 3 illustrated in Fig. 4, the height of the filling member 30 may be substantially the same as the height of a layered body of the light emitting elements 10, the first phosphor layer 20, and the second phosphor layer 60, and the side surfaces of the first phosphor layer 20 and the second phosphor layer 60 may be in contact with the filling member 30. Since the side surfaces of the first phosphor layer 20 and the side surfaces of the second phosphor layer 60 are covered with the filling member 30 in this manner, heat generated in the first phosphor layer 20 and the second phosphor layer 60 can be conducted to the filling member 30 and dissipated. Thus, the heat dissipation of the first phosphor layer 20 and the second phosphor layer 60 can be further enhanced.

### [Third embodiment]

Next, a light emitting device according to a third embodiment will be described in detail. Note that the same components as those of the first and second embodiments are denoted by the same reference numerals, and duplicate descriptions thereof will be omitted.

As illustrated in Fig. 5, a light emitting device 4 according to the third embodiment includes the multiple light emitting elements 10 arranged at a predetermined interval, the first phosphor layer 20, and the filling members 30 and 30A. Similar to the light emitting device 3 illustrated in Fig. 4, the second phosphor layer 60 is layered on the first phosphor layer 20, and the side surfaces of the first phosphor layer 20 and the side surfaces of the second phosphor layer 60 are covered with the filling member 30.

As described in the second embodiment, in the light emitting device 2, the heat dissipation of the first phosphor layer 20 and the second phosphor layer 60 is improved. Thus, even if a phosphor layer 70 is further layered on the second phosphor layer 60, temperature rise of the first phosphor layer 20 and the second phosphor layer 60 can be controlled. By further providing the phosphor layer 70 in addition to the first phosphor layer 20 and the second phosphor layer 60, it is possible to obtain a light emitting device capable of emitting fluorescence of multiple wavelengths.

The third phosphor layer 70 may be made from a phosphor ceramic obtained by sintering phosphor, or may be a wavelength conversion member in which phosphor is dispersed in a translucent material. The translucent material used in the wavelength conversion member may be a resin, for example, a silicone resin. Although the phosphor included in the third phosphor layer 70 is not particularly limited, at least one of blue phosphor, green phosphor, yellow phosphor, red phosphor, or near-infrared phosphor may be used. Note that the above-mentioned blue phosphor, green phosphor, yellow phosphor, red phosphor, and near-infrared phosphor can be used.

In the light emitting device 4, the third phosphor layer 70 is layered on an upper surface 61 of the second phosphor layer 60, and is a single plate-like member covering the upper surface 61 of the second phosphor layer 60. The third phosphor layer 70 may be directly layered on the upper surface 61 of the second phosphor layer 60, or may be layered via an adhesive layer. The adhesive layer for bonding the second phosphor layer 60 and the third phosphor layer 70 is not particularly limited, but, for example, at least one of an inorganic adhesive or an organic adhesive, each having light transparency, may be used.

The action of the light emitting device 4 according to the present embodiment, which has the above configuration, will be described. In the light emitting device 4 according to the present embodiment, when power is applied to the light emitting elements 10, excitation light (primary light) is emitted upward from the light emitting elements 10. The emitted excitation light passes through the first phosphor layer 20, the second phosphor layer 60, and the third phosphor layer 70, and at this time, part of the excitation light is absorbed by fluorescent ions of phosphor included in the first phosphor layer 20 and the second phosphor layer 60. Similarly, part of the excitation light is absorbed by fluorescent ions of phosphor included in the third phosphor layer 70. The absorbed excitation energy is then converted into fluorescence through electronic energy transition of the fluorescent ions, and the fluorescence is emitted upward from the phosphor. Note that the light emitting device 4 may have a configuration where the phosphor in the third phosphor layer 70 absorbs fluorescence emitted from the phosphor in the first phosphor layer 20 and/or the second phosphor layer 60, and emit fluorescence having a longer wavelength.

In the light emitting device 4, the phosphor included in the first phosphor layer 20 can be (Ga,Sc)₂O₃:Cr³⁺, which is near-infrared phosphor, and the phosphor included in the second phosphor layer 60 can be Gd₃Ga₂(GaO₄)₃:Cr³⁺, which is a near-infrared phosphor. The phosphor included in the third phosphor layer 70 can be CaAlSiN₃:Eu²⁺, which is red phosphor. By using such phosphor, it is possible to obtain the light emitting device 4 capable of emitting near-infrared light and red light. The light emitting device 4 can be used as a light source for performing quality inspection of an inspection object by use of near-infrared light and red light.

In the light emitting device 4, the third phosphor layer 70 is preferably a wavelength conversion member in which phosphor particles are dispersed in a translucent resin. The refractive index of the translucent resin is intermediate between the refractive index of the second phosphor layer 60 made from a phosphor ceramic and the refractive index of air. That is, when fluorescence transmitted through the second phosphor layer 60 is emitted to the outside of the light emitting device 4, the third phosphor layer 70 functions as an intermediate refractive index layer between the phosphor ceramic and air. Thus, extraction efficiency of light from the light emitting device 4 can be improved.

### (Note)

The description of the above embodiments discloses the following techniques.

(Technique 1) A light emitting device including: a plurality of light emitting elements arranged at a predetermined interval; a first phosphor layer made from phosphor ceramic; and a filling member that covers side surfaces of the plurality of light emitting elements and is provided between adjacent light emitting elements, wherein the first phosphor layer is a single plate-like member that covers light output surfaces of the plurality of light emitting elements, and the first phosphor layer is arranged to be in contact with the plurality of light emitting elements and the filling member.

With this configuration, heat generated in the regions 22 of the first phosphor layer 20 is conducted to the region 23 having a relatively low temperature, is further conducted from the region 23 to the filling member 30A, and is then conducted to the substrate 40. At the same time, heat generated in the regions 22 of the first phosphor layer 20 is conducted to the light emitting elements 10, and is further conducted from the light emitting elements 10 to the substrate 40. Thus, since heat dissipation in the first phosphor layer 20 is efficiently performed, it becomes possible to control temperature quenching of the phosphor.

(Technology 2) The light emitting device according to technology 1, wherein when a light output surface side of the plurality of light emitting elements is seen in plan view, outer dimensions of the first phosphor layer are substantially equal to outer dimensions of the plurality of light emitting elements.

With this configuration, output light emitted from the light emitting device becomes less likely to diffuse. Thus, the output light easily enters into a lens provided near the light emitting device, and the lens can be made compact. Furthermore, through reduction in size of the lens, a housing for holding the lens and the light emitting device therein can also be made compact.

(Technology 3) The light emitting device according to a technology 1 or 2, further including a second phosphor layer that is layered on the first phosphor layer.

In the light emitting device according to the present embodiment, since the heat dissipation of the first phosphor layer 20 is improved, temperature rise of the first phosphor layer 20 can be controlled even if the second phosphor layer 60 is further layered on the first phosphor layer 20. Furthermore, by providing the second phosphor layer 60 in addition to the first phosphor layer 20, it is possible to obtain a light emitting device that emits fluorescence of multiple wavelengths.

(Technology 4) The light emitting device according to a technology 3, wherein the second phosphor layer is made from a phosphor ceramic.

With this configuration, the heat emitted from the phosphor in the second phosphor layer 60 can be efficiently dissipated, and temperature quenching of the phosphor can be controlled.

(Technology 5) The light emitting device according to a technology 3 or 4, wherein when a light output surface side of the plurality of light emitting elements is seen in plan view, outer dimensions of the second phosphor layer are substantially equal to outer dimensions of the first phosphor layer.

With this configuration, the output light emitted from the light emitting device becomes less likely to diffuse. Thus, the output light easily enters into a lens provided near the light emitting device, and the lens can be made compact. Furthermore, through reduction in size of the lens, a housing for holding the lens and the light emitting device therein can also be made compact.

(Technology 6) The light emitting device according to any one of technologies 3 to 5, wherein the second phosphor layer is bonded to the first phosphor layer.

With this configuration, the first phosphor layer 20 and the second phosphor layer 60 are bonded, and the first phosphor layer 20 and the second phosphor layer 60 can be brought into close contact at their interface. Thus, heat conduction between the first phosphor layer 20 and the second phosphor layer 60 is facilitated, and thereby the heat dissipation of the first phosphor layer 20 and the second phosphor layer 60 can be enhanced.

(Technique 7) The light emitting device according to any one of techniques 3 to 6, wherein side surfaces of the first phosphor layer and side surfaces of the second phosphor layer are covered by the filling member.

With this configuration, heat generated in the first phosphor layer 20 and the second phosphor layer 60 can be conducted to the filling member 30 and dissipated. Thus, it becomes possible to further enhance the heat dissipation of the first phosphor layer 20 and the second phosphor layer 60.

(Technique 8) The light emitting device according to any one of techniques 1 to 7, wherein the filling member includes a reflective material that reflects light.

With this configuration, since the excitation light emitted from the light emitting elements 10 and the fluorescence emitted from the phosphor are reflected, the spread of light radiated from the light emitting elements 10, the first phosphor layer 20, and the second phosphor layer 60 can be controlled, thereby reducing leakage light. Thus, it is possible to enhance the light emission efficiency of the light emitting device.

(Technology 9) The light emitting device according to any one of technologies 3 to 8, further including: one or more phosphor layers that is layered on the second phosphor layer.

In the light emitting device according to the present embodiment, since the heat dissipation of the first phosphor layer 20 and the second phosphor layer 60 is improved, even if the phosphor layer 70 is further layered on the second phosphor layer 60, it is possible to control temperature rise of the first phosphor layer 20 and the second phosphor layer 60. By further providing the phosphor layer 70 in addition to the first phosphor layer 20 and the second phosphor layer 60, it is possible to obtain a light emitting device that emits fluorescence of multiple wavelengths.

(Technology 10) The light emitting device according to any one of technologies 3 to 9, further including: a third phosphor layer that is layered on the second phosphor layer, wherein the third phosphor layer includes phosphor particles and a resin for dispersing the phosphor particles.

With this configuration, it is possible to obtain a light emitting device that emits fluorescence of multiple wavelengths. Furthermore, since the third phosphor layer 70 functions as an intermediate refractive index layer between the phosphor ceramic and air, extraction efficiency of light from the light emitting device can be improved.

### EXAMPLES

Hereinafter, the present embodiment will be described in more detail with reference to examples and comparative examples, but the present embodiment is not limited to these examples.

### [Example 1]

### (Production of first phosphor layer)

First, a first phosphor layer used in a light emitting device was synthesized using a synthesis method utilizing a solid-state reaction. The first phosphor configuring the first phosphor layer is near-infrared phosphor, which is oxide phosphor represented by the composition formula (Ga_{0.59}Cr_{0.01}Sc_{0.4})₂O₃. Note that in this description, the (Ga, Sc)₂O₃:Cr³⁺ phosphor is also referred to as a "GaSc phosphor".

In the synthesis of the first phosphor layer, the following compound powders were used as main raw materials.
Gallium oxide (Ga₂O₃): purity 4N, Nippon Rare Metal, Inc.
Dichromium trioxide (Cr₂O₃): purity 3N, Kojundo Chemical Laboratory Co., Ltd.
Scandium oxide (Sc₂O₃): purity >3N, Kojundo Chemical Laboratory Co., Ltd.

In order to enhance reactivity of the raw materials, the following compound powder was used as a reaction accelerator.
Boric acid (H₃BO₃): FUJIFILM Wako Pure Chemical Corporation

First, the raw materials were weighed to obtain a compound (Ga_{0.59}Cr_{0.01}Sc_{0.4})₂O₃ of a stoichiometric composition. The reaction accelerator was weighed to have a molar percentage of 3% to the target compound ((Ga_{0.59}Cr_{0.01}Sc_{0.4})₂O₃). Next, the weighed raw materials and reaction accelerator were charged into a cylindrical container, and an appropriate amount of pure water was injected. Then, the container containing the raw materials, the reaction accelerator, and the pure water was set in a planetary mill apparatus (PULVERISETTE5 manufactured by Fritsch Japan Co., Ltd.), and the raw materials and the reaction accelerator were thoroughly wet-mixed. Note that the rotational speed of the planetary mill apparatus was 200 rpm, and the mixing time was 30 minutes.

Next, a slurry raw material including the raw materials, the reaction accelerator, and the pure water was transferred to a metal container having a Naflon^{®} sheet placed therein, and dried at 150 °C for about 3 hours by using a dryer, evaporating the pure water. The dried raw materials were lightly pulverized by using a mortar and a pestle. Then, coarse particles of the pulverized raw materials were removed by using a mesh having a mesh opening of about 512 µm. In this way, a mixed raw material of the first phosphor layer was obtained.

Next, the mixed raw material of the first phosphor layer was molded into a thin cylindrical shape using a manual hydraulic press (manufactured by RIKEN SEIKI CO., LTD.) and a cylindrical die (φ13 mm). Note that pressure applied to a pressure receiving surface of a sample during molding was about 20 MPa. Thus, a molded body of the mixed raw material was obtained.

Next, the molded body of the mixed raw material was fired using a box-type atmospheric furnace. Processing temperature was 1,400 °C, and processing time was 4 hours. Thus, a fired body of the mixed raw material was obtained.

Then, the upper and bottom surfaces of the fired product were ground using a grinding apparatus (DFD6340, manufactured by DISCO CORPORATION). The grit number of a grinding blade used for grinding was set to #1400. Note that the thickness of the fired body after grinding was about 100 µm. Next, the fired body after grinding was diced into a thin rectangular parallelepiped shape using a dicing apparatus (DAD3350, manufactured by DISCO CORPORATION). The outer dimensions in plan view after dicing were about 3.3 mm in length and about 2.6 mm in width. In this way, a first phosphor layer formed by sintering (Ga, Sc)₂O₃:Cr³⁺ was obtained.

### (Production of second phosphor layer)

Next, a second phosphor layer used in a light emitting device was synthesized using a synthesis method utilizing a solid-state reaction. The second phosphor configuring the second phosphor layer is near-infrared phosphor, which is oxide phosphor represented by the composition formula Gd₃(Ga_{0.97}Cr_{0.03})₂Ga₃O₁₂. Note that in this description, the Gd₃Ga₂Ga₃O₁₂:Cr³⁺ phosphor is also referred to as a "GGG phosphor".

In the synthesis of the second phosphor layer, the following compound powders were used as main raw materials.
Gadolinium oxide (Gd₂O₃): purity 4N, Nippon Yttrium Co., Ltd.
Gallium oxide (Ga₂O₃): purity 4N, Nippon Rare Metal, Inc.
Dichromium trioxide (Cr₂O₃): purity 3N, Kojundo Chemical Laboratory Co., Ltd.

First, the raw materials were weighed to obtain a compound Gd₃(Ga_{0.97}Cr_{0.03})₂Ga₃O₁₂ of a stoichiometric composition. Next, the weighed raw materials and reaction accelerator were charged into a cylindrical container, and an appropriate amount of ethanol was injected. Then, the container containing the raw materials, the reaction accelerator, and the ethanol was set in a planetary mill apparatus (PULVERISETTE5 manufactured by Fritsch Japan Co., Ltd.), and the raw materials and the reaction accelerator were thoroughly wet-mixed. Note that the rotational speed of the planetary mill apparatus was 200 rpm, and the mixing time was 30 minutes.

Next, a slurry raw material including the raw materials, the reaction accelerator, and the ethanol was transferred to a metal container having a Naflon^{®} sheet placed therein, and dried at 125 °C for about 2 hours by using a dryer, evaporating the ethanol. The dried raw materials were lightly pulverized by using a mortar and a pestle. Then, coarse particles of the pulverized raw materials were removed by using a mesh having a mesh opening of about 516 µm. In this way, a mixed raw material of the second phosphor layer was obtained.

Next, the mixed raw material of the second phosphor layer was molded into a thin cylindrical shape using a manual hydraulic press (manufactured by RIKEN SEIKI CO., LTD.) and a cylindrical die (φ13 mm). Note that pressure applied to a pressure receiving surface of a sample during molding was about 20 MPa. Thus, a molded body of the mixed raw material was obtained.

Next, the molded body of the mixed raw material was fired using a Tamman tube type atmosphere electric furnace. Firing atmosphere was nitrogen, processing temperature was 1,600 °C, and processing time was 2 hours. Thus, a fired body of the mixed raw material was obtained.

Then, the upper and bottom surfaces of the fired product were ground using a grinding apparatus (DFD6340, manufactured by DISCO CORPORATION). The grit number of a grinding blade used for grinding was set to #1400. Note that the thickness of the fired body after grinding was about 100 µm. Next, the fired body after grinding was diced into a thin rectangular parallelepiped shape using a dicing apparatus (DAD3350, manufactured by DISCO CORPORATION). The outer dimensions in plan view after dicing were about 3.3 mm in length and about 2.6 mm in width. In this way, a second phosphor layer formed by sintering Gd₃Ga₂Ga₃O₁₂:Cr³⁺ was obtained.

### (Density measurement of first phosphor layer and second phosphor layer)

The densities of the first phosphor layer and the second phosphor layer obtained as described above were measured. Specifically, the weight and the volume of the first phosphor layer were measured, and the density of the first phosphor layer was evaluated by dividing the measured weight by the measured volume. As a result of the evaluation, the density of the first phosphor layer was 4.59 g/cm³. The density of the second phosphor layer was evaluated using the Archimedes method. As a result of the evaluation, the density of the second phosphor layer was 6.94 g/cm³.

### (Calculation of thermal conductivities of first phosphor layer and second phosphor layer)

Specific heat capacities and thermal diffusivities of the first phosphor layer and the second phosphor layer were evaluated using a xenon flash analyzer (NETZSCH Japan K.K., LFA447). As a result of the evaluation, the specific heat capacities of the first phosphor layer and the second phosphor layer were 0.561 J/g/K and 0.352 J/g/K, respectively. The thermal diffusivities of the first phosphor layer and the second phosphor layer were 3.36 mm²/s and 2.67 mm²/s, respectively.

Here, since the thermal conductivity is a product of the density, the specific heat capacity, and the thermal diffusivity, the thermal conductivities of the first phosphor layer and the second phosphor layer were calculated using this equation. As a result, the thermal conductivities of the first phosphor layer and the second phosphor layer were 8.64 J/s/m/K and 6.52 J/s/m/K, respectively.

### (Production of light emitting device)

A light emitting device was produced using the first phosphor layer and the second phosphor layer obtained as described above. First, a commercially available multi-chip LED package including a substrate, four blue LEDs, and a dam material was prepared.

The four blue LEDs were mounted on the substrate and arranged in two rows in the X-axis direction and two rows in the Y-axis direction as illustrated in Fig. 1C. Adjacent blue LEDs were arranged at a predetermined interval. Note that the outer dimensions of each blue LED were about 1.2 mm × 1.5 mm, and the interval between adjacent blue LEDs was about 0.15 mm. The outer dimensions of the four blue LEDs were about 2.6 × 3.2 mm.

As illustrated in Fig. 1C, the dam material was provided all around the four blue LEDs.

Next, a white resin as a filling member was applied between the four blue LEDs and the dam material and between the adjacent blue LEDs in the multi-chip LED package, and cured to form the filling member. Note that the white resin used was LED silicone KER-2016WC-A/B manufactured by Shin-Etsu Chemical Co., Ltd.

Next, the first phosphor layer was bonded onto the blue LEDs using an adhesive. Note that the adhesive used was LED silicone KER-2600-A/B manufactured by Shin-Etsu Chemical Co., Ltd.

In this manner, as illustrated in Figs. 1A and 1B, a light emitting device of example 1-1 including the first phosphor layer was obtained. Note that in the present example, the height of the filling member was adjusted such that the side surfaces of the first phosphor layer were in contact with the filling member. In the light emitting device of example 1-1, the difference between the outer dimensions of the four blue LEDs and the outer dimensions of the first phosphor layer was 5% or less.

Furthermore, the second phosphor layer was bonded on the first phosphor layer in the light emitting device of example 1-1. Note that the adhesive used was LED silicone KER-2600-A/B manufactured by Shin-Etsu Chemical Co., Ltd.

In this manner, as illustrated in Fig. 4, a light emitting device of example 1-2 including the first phosphor layer and the second phosphor layer was obtained. Note that in the present example, the height of the filling member was adjusted such that the side surfaces of the first phosphor layer and the second phosphor layer were in contact with the filling member. In the light emitting device of example 1-2, the difference between the outer dimensions of the four blue LEDs and the outer dimensions of the first phosphor layer was 5% or less. Furthermore, the difference between the outer dimensions of the first phosphor layer and the outer dimensions of the second phosphor layer was 5% or less.

### (Beam profile of light emitting device)

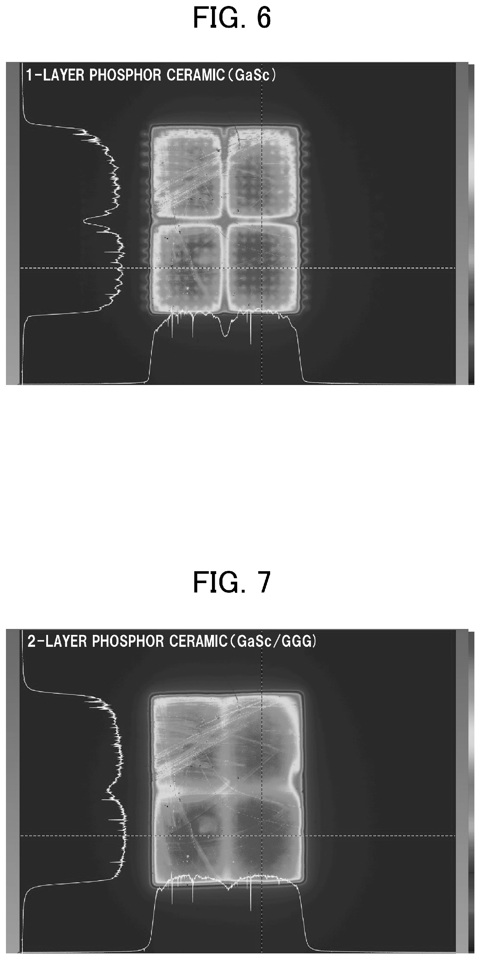

The emission intensity distribution of light emitted from each of the light emitting devices of examples 1-1 and 1-2 was measured using a beam profiler. Fig. 6 illustrates the emission intensity distribution of the light emitting device of example 1-1, and Fig. 7 illustrates the emission intensity distribution of the light emitting device of example 1-2. Note that since the near-infrared phosphor in the first phosphor layer and the second phosphor layer absorbs blue light and performs wavelength conversion to near-infrared light, a portion having a large emission intensity can be regarded as a portion having a large heat generation.

As illustrated in Fig. 6, it can be seen that the light emitting device of example 1-1 has high emission intensity and large heat generation in a region directly above the blue LEDs. In contrast, it can be seen that a region between the blue LEDs has low emission intensity, and thus low heat generation. Furthermore, it can be seen that a region near the side surfaces of the first phosphor layer also has low emission intensity and low heat generation.

As illustrated in Fig. 7, in the light emitting device of example 1-2, it can be seen that a region directly above the blue LEDs has high emission intensity and large heat generation. In contrast, it can be seen that a region between the blue LEDs has low emission intensity and thus low heat generation. Furthermore, it can be seen that a region near the side surfaces of the second phosphor layer also has low emission intensity and low heat generation.

### [Example 2]

Next, CAE (computer aided engineering) analysis was performed on temperature distributions of the first phosphor layer and the second phosphor layer in light emitting devices of examples 2-1 to 2-3 and comparative example 2-1 to 2-3.

### (Analytical model)

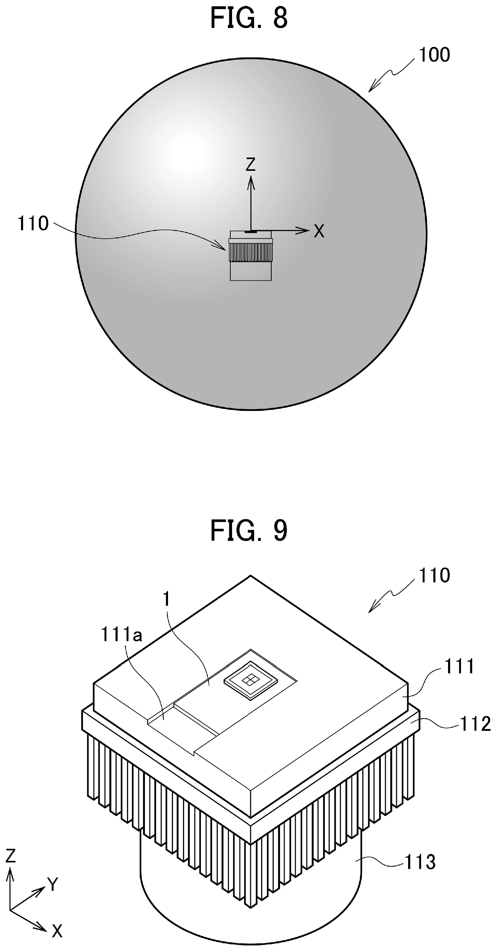

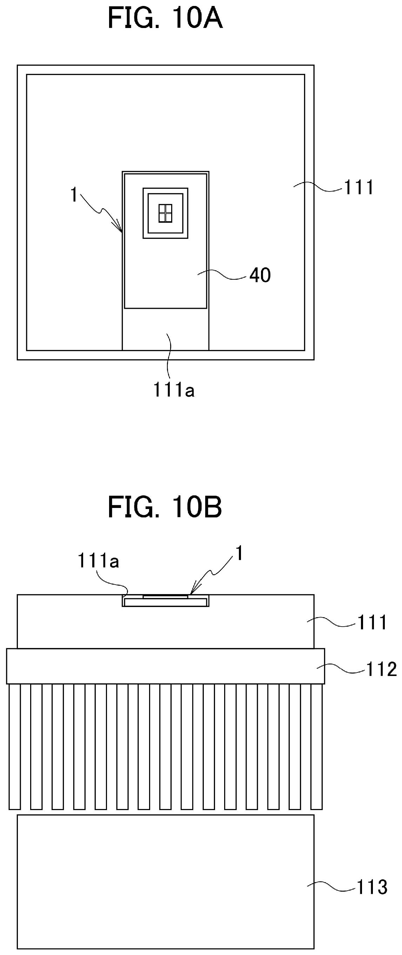

Fig. 8 illustrates the overall shape of an analytical model used in the CAE analysis, and Figs. 9, 10A, and 10B schematically illustrate a light emitting module. As illustrated in Fig. 8, in the CAE analysis, a spherical region of Φ450 mm in diameter and including air was set as a surrounding region 100. At this time, the origin was set at the center of the surrounding region 100, and the direction of gravity was set to the negative Z direction. Note that the spherical region was assumed to be an integrated sphere. A light emitting module 110 was arranged such that a light emitting part (light emitting element) was located at the center of the surrounding region 100.

The light emitting module 110 includes an aluminum base 111, a heat sink 112, and a fan 113. Note that the light emitting module 110 does not include a lens and a cylindrical casing. The light emitting module 110 was arranged such that the direction in which light is emitted is upward (Z direction).

The aluminum base 111 is made from aluminum, and has a counterbore 111a formed on its upper surface for holding the light emitting device 1. The aluminum base 111 had dimensions of 55 mm in length (X direction), 55 mm in width (Y direction), and 10 mm in height (Z direction), with a counterbore depth of 2 mm. The thermal conductivity of the aluminum base 111 was set to 138 W/m·K.

The heat sink 112 has the aluminum base 111 disposed on its upper surface, and had dimensions of 59 mm in length, 59 mm in width, and 30 mm in height. The thermal conductivity of the heat sink 112 was set to 180 W/m·K.

The fan 113 is cylindrical, and has the heat sink 112 disposed on its upper surface. The fan 113 had dimensions of Φ55 mm in diameter and 25 mm in height. Note that the fan 113 was configured to generate only an upward wind at a wind velocity of 2 m/s.

Note that a contact thermal resistance simulating a thermal interface material (TIM) was set between the light emitting device 1 and the aluminum base 111, and between the aluminum base 111 and the heat sink 112. The contact thermal resistance has a thickness of 300 µm, and a thermal conductivity set to 1.5 W/m·K.

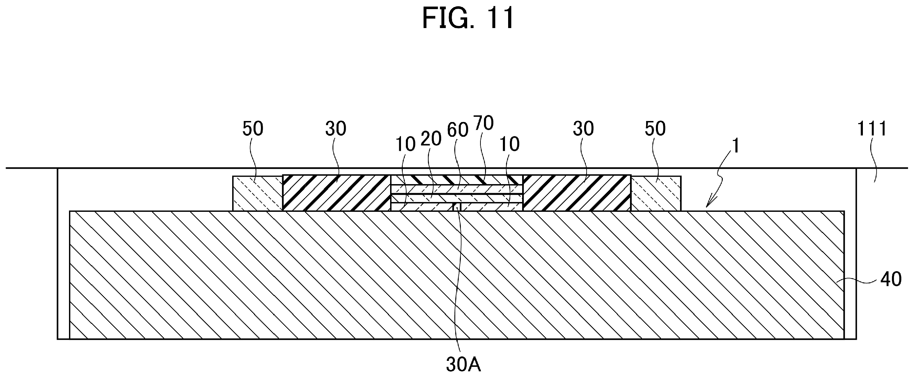

As illustrated in Figs. 10A and 11, the light emitting device 1 includes the multiple light emitting elements 10, the first phosphor layer 20, the second phosphor layer 60, the third phosphor layer 70, the filling members 30 and 30A, the substrate 40, and the dam material 50. The light emitting elements 10 were each an LED formed by layering GaN and Si₃N₄. The GaN had a thickness of 10 µm, a thermal conductivity of 160 W/m·K, and an amount of heat generation of 22.07 W. The Si₃N₄ had a thickness of 90 µm and a thermal conductivity of 85 W/m·K.

The first phosphor layer 20 was phosphor ceramic made from GaSc phosphor, and had a thickness of 100 µm, a thermal conductivity of 8.6 W/m·K, and an amount of heat generation of 8.00 W. The second phosphor layer 60 was phosphor ceramic made from GGG phosphor, and had a thickness of 100 µm, a thermal conductivity of 6.5 W/m·K, and an amount of heat generation of 1.84 W. The third phosphor layer 70 was CASN paste in which CASN was dispersed in a silicone resin, and had a thickness of 120 µm, a thermal conductivity of 0.2 W/m·K, and an amount of heat generation of 0.72 W.

Note that a contact thermal resistance simulating an adhesive was set between the substrate 40 and the light emitting elements 10, with a thickness of 20 µm and a thermal conductivity of 57 W/m·K. A contact thermal resistance simulating an adhesive was also set between the light emitting elements 10 and the first phosphor layer 20, with a thickness of 10 µm and a thermal conductivity of 0.2 W/m·K. A contact thermal resistance simulating an adhesive was also set between the first phosphor layer 20 and the second phosphor layer 60, with a thickness of 10 µm and a thermal conductivity of 0.2 W/m·K.

The filling members 30 and 30A had a thickness of 0.42 mm, and a thermal conductivity set to 0.2 W/m·K. The dam material 50 had a length (X direction) of 9 mm, a width (Y direction) of 10 mm, a height (Z direction) of 0.4 mm, and a width of 1 mm, and a thermal conductivity set to 0.2 W/m·K. The substrate 40 was made of a copper substrate, and had dimensions of 15.5 mm in length (X direction), 27 mm in width (Y direction), and 1.5 mm in height (Z direction). The thermal conductivity of the substrate 40 was set to 398 W/m·K.

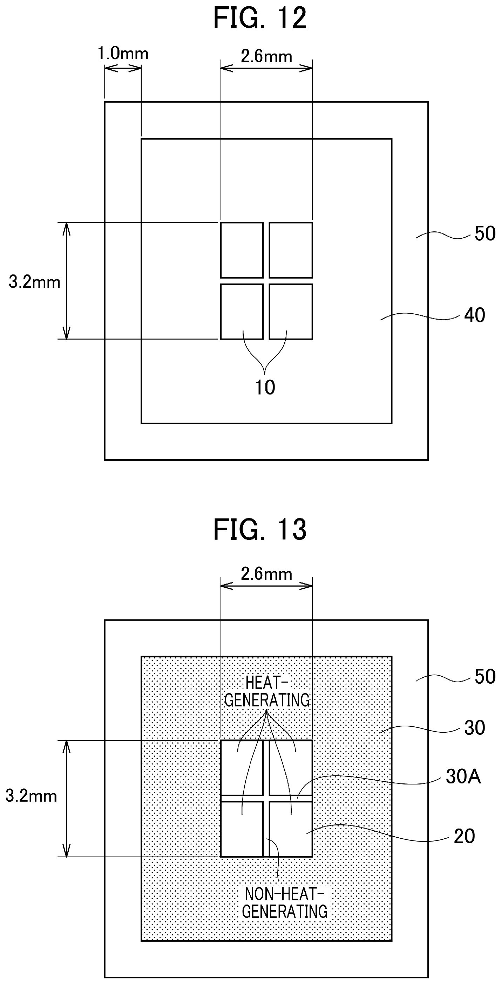

Fig. 12 illustrates the arrangement of four light emitting elements 10 mounted on the substrate 40, and the dam material 50. As illustrated in Fig. 12, the four light emitting elements 10 are arranged in two rows in the X-axis direction and two rows in the Y-axis direction, and the dam material 50 is provided all around the light emitting elements. Adjacent light emitting elements 10 are arranged at a predetermined interval. Note that the outer dimensions of the four light emitting elements 10 in the Y-axis direction and in the X-axis direction were 3.2 mm and 2.6 mm, respectively. The dimensions of each light emitting element 10 were 1.525 mm × 1.225 mm, and the interval between adjacent light emitting elements was set to 0.15 mm.

Fig. 13 illustrates a state in which the filling members 30 and 30A are provided between the four light emitting elements 10 and the dam material 50, and a phosphor layer (first phosphor layer and second phosphor layer) is layered on the four light emitting elements 10. The outer dimensions of the phosphor layer in the Y-axis direction and in the X-axis direction were set to 3.2 mm and 2.6 mm, respectively. Note that in the analytical model of Fig. 13, only a portion of the phosphor layer, which was positioned directly above the light emitting elements 10, was defined as a heating region, and a portion of the phosphor layer, which was not positioned directly above the light emitting elements 10, was defined as a non-heating region.

Table 1 summarizes components and set values of the analytical model of example 2, and Table 2 summarizes set values of contact resistance between components. Note that as analytical conditions other than the set values of Tables 1 and 2, the ambient temperature of the surrounding region 100 was 30 °C, the wind velocity of the fan 113 was 2.0 m/s, the wind direction was in the positive Z direction, and gravity was in the negative Z direction. The CAE analysis was a steady-state analysis, and the number of cycles was 1,000.

**[Table 1]**

| Components | | Material | Mesh size (mm) | Heat generation amount (W) | Thermal conductivity (W/mK) | Emissivity (-) |
|---|---|---|---|---|---|---|
| Phosphor layer | Third phosphor layer | CASN, silicone | 0.060 | - | 0.2 | 0.95 |
| | Second phosphor layer | GGG ceramic | 0.050 | 1.84 | 6.5 | 0.90 |
| | First phosphor layer | GaSc ceramic | 0.050 | 8.00 | 8.6 | 0.90 |
| Light emitting elements | LED chip | GaN | 0.005 | 22.07 | 160.0 | 0.90 |
| | LED chip | Si₃N4 | 0.045 | - | 85.0 | 0.90 |
| | Substrate | Cu | 0.750 | - | 398.8 | 0.95 |
| | Dam | Silicone | 0.400 | - | 0.2 | 0.95 |
| Filling member | | Silicone | 0.210 | - | 0.2 | 0.95 |
| Aluminum base | | A-5052 | 4.000 | - | 138.0 | 0.40 |
| Heat sink | | A-6061 | 2.000 | - | 180.0 | 0.40 |
| Fan | | Air | 6.250 | - | 0.0256 | 0.00 |
| Surrounding region | | Air | 20.000 | - | 0.0256 | 0.00 |

**[Table 2]**

| Contact resistance setting surface | | Material | Thermal conductivity (W/mK) | Thickness (mm) | Heat transfer coefficient (W/m² · K) |
|---|---|---|---|---|---|
| Second phosphor layer | First phosphor layer | Silicone | 0.2 | 0.010 | 20,000 |
| First phosphor layer | LED chip (GaN) | Silicone | 0.2 | 0.010 | 20,000 |
| LED chip (Si₃N₄) | Substrate | AuSn solder | 57.0 | 0.020 | 2,850,000 |
| Substrate | Aluminum base | Heat dissipation sheet | 1.5 | 0.300 | 5,000 |
| Aluminum base | Heat sink | Heat dissipation sheet | 1.5 | 0.300 | 5,000 |

### (Structures of light emitting devices of examples 2-1 to 2-3 and comparative examples 2-1 to 2-3)

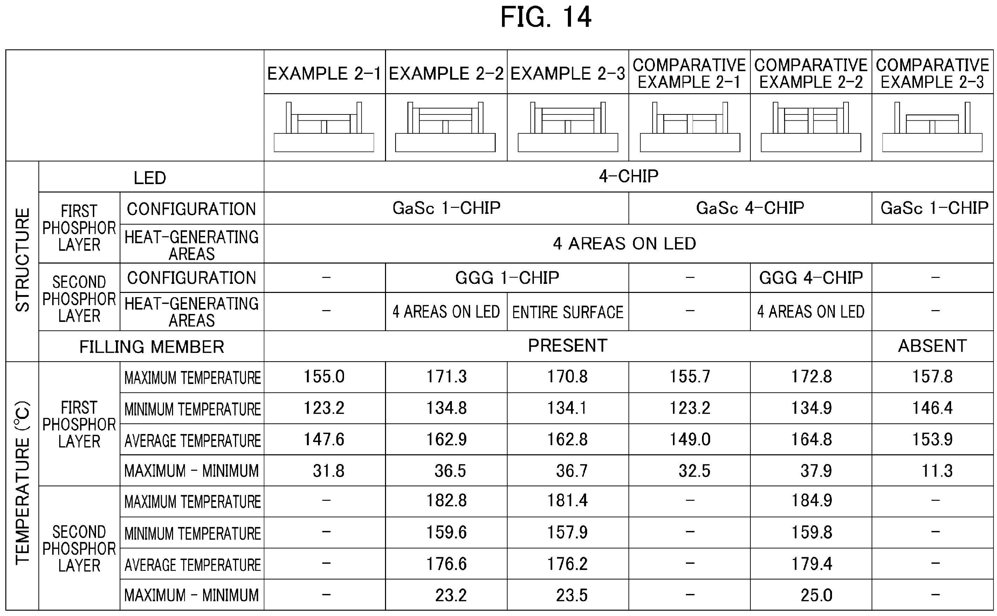

Fig. 14 illustrates the structures of light emitting devices ef examples 2-1 to 2-3 and comparative examples 2-1 to 2-3 subjected to CAE analysis. The light device of examples 2-1 includes the light emitting elements 10, the first phosphor layer 20, the fillling members 30 and 30A, the substrate 40, and the damn material 50. The light emitting devices of examples 2-2 and example 2-3 include the light emitting elements 10, the first phosphor layer 20, the second phosphor layer 60, the filling members 30 and 30A, the substrate 40, and the dam material 50. Note that in the light emitting device of example 2-2, the second phosphor layer 60 located directly above the light emitting elements 10 was used as a heat generating area. In the light emitting device of example 2-3, the entire surface of the second phosphor layer 60 was used as a heat generating area.

The light emitting element of comparative example 2-1 includes the light emitting elements 10, the first phosphor layer 20, the filling members 30 and 30A, the substrate 40, and the dam material 50, as in example 2-1. However, as illustrated in Fig. 14, the first phosphor layer 20 is not a single plate-like member but is divided into four pieces, each layered only directly above a corresponding one of the four light emitting elements 10. Thus, the filling member 30A is filled between adjacent light emitting elements 10 and between adjacent first phosphor layers 20.

The light emitting device of comparative example 2-2 includes the light emitting elements 10, the first phosphor layer 20, the second phosphor layer 60, the filling members 30 and 30A, the substrate 40, and the dam material 50. However, as illustrated in Fig. 14, the first phosphor layer 20 is not a single plate-like member but is divided into four pieces, each layered only directly above a corresponding one of the four light emitting elements 10. Similarly, the second phosphor layer 60 is not a single plate-like member but is divided into four pieces, each layered only directly above a corresponding one of the four light emitting elements. Thus, the filling member 30A is filled between adjacent light emitting elements 10, between adjacent first phosphor layers 20, and between adjacent second phosphor layers 60.

The light emitting device of comparative example 2-3 includes the light emitting elements 10, the first phosphor layer 20, the substrate 40, and the dam material 50. That is, the light emitting device of comparative example 2-3 has a configuration in which the filling members 30 and 30A are removed from the light emitting device of example 2-1.

### (Results of CAE analysis)

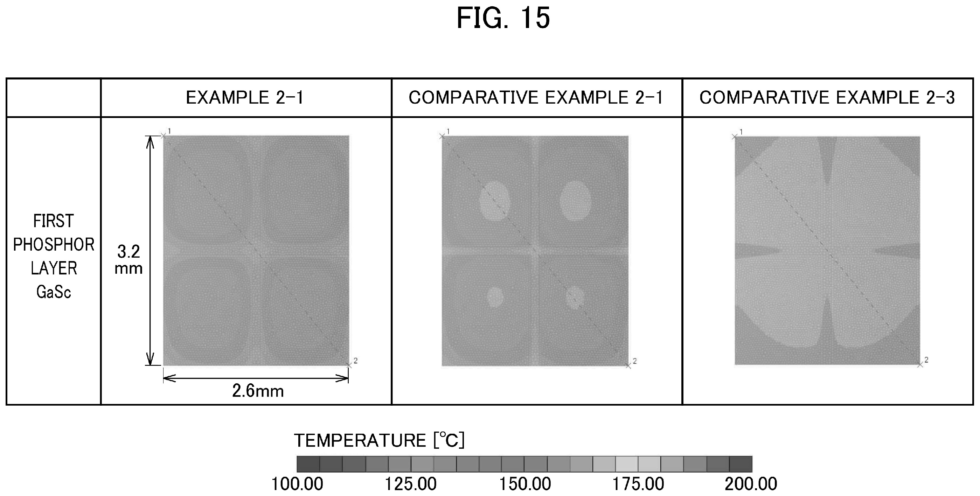

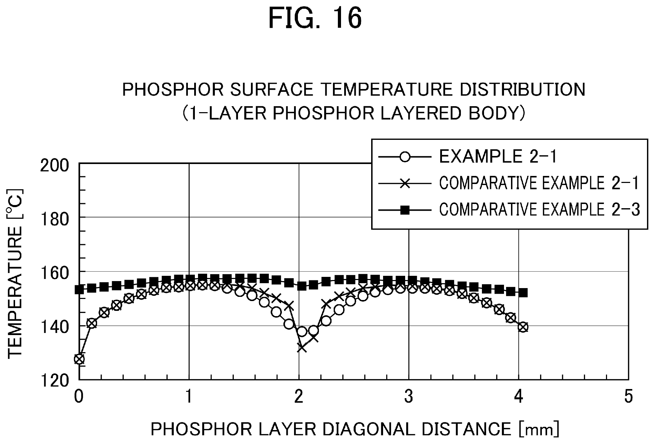

Fig. 14 illustrates results of CAE analysis, specifically, temperatures of the surfaces of the first phosphor layer 20 and the second phosphor layer 60 on the light output surface side in examples and comparative examples. Fig. 15 illustrates temperature distributions (contour diagrams) on the surface of the first phosphor layer 20 on the light output surface side in each of the light emitting devices of example 2-1, comparative example 2-1, and comparative example 2-3. Note that in comparative example 2-1 of Fig. 15, the temperature distribution of the filling member present between the first phosphor layers is also illustrated in addition to that of the first phosphor layers. Fig. 16 illustrates the results of plotting temperatures along the diagonal of the first phosphor layers in the temperature distributions of Fig. 15. Specifically, Fig. 16 illustrates the relationship between the diagonal distance and the surface temperature of the first phosphor layer 20 along the dotted line in Fig. 15.

As illustrated in Fig. 16, it can be seen that the surface temperature of the first phosphor layer 20 in the light emitting device of example 2-1 is lower as a whole than that of the light emitting device of comparative example 2-3 having no filling member. It can also be seen that the surface temperature of the light emitting device of comparative example 2-1 is lower in the diagonal distance range of 2 to 2.2 mm where the filling member is present, but is higher in other parts than that of the light emitting device of example 2-1.

As described above, by forming the first phosphor layer as a single plate-like member and arranging the first phosphor layer to be in contact with the multiple light emitting elements and the filling member, heat conduction is generated toward the region 23 where the amount of heat generation is small and the filling member 30A. As a result, it can be seen that heat dissipation from the first phosphor layer is efficiently performed.

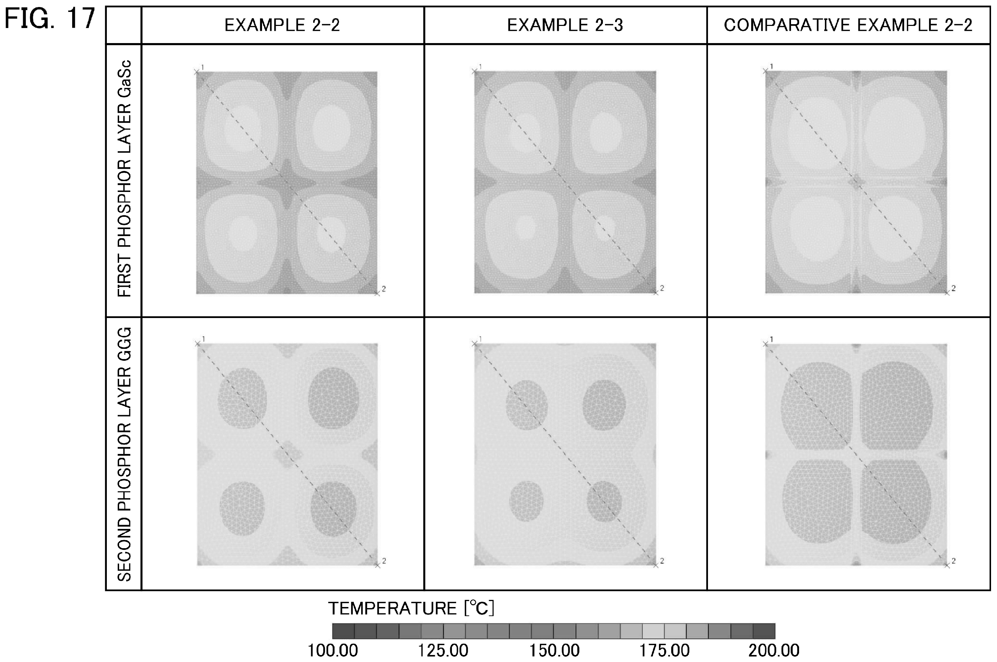

Fig. 17 illustrates results of CAE analysis, and specifically, illustrates temperature distributions (contour diagrams) of surfaces of the first phosphor layer 20 and the second phosphor layer 60 on the light output surface side in each of the light emitting devices of example 2-2, example 2-3, and comparative example 2-2. Note that in comparative example 2-2 of Fig. 17, the temperature distribution of the filling member present between first phosphor layers is also illustrated in addition to that of the first phosphor layers. Similarly, in comparative example 2-2 of Fig. 17, the temperature distribution of the filling member present between second phosphor layers is also illustrated, in addition to that of the second phosphor layers.

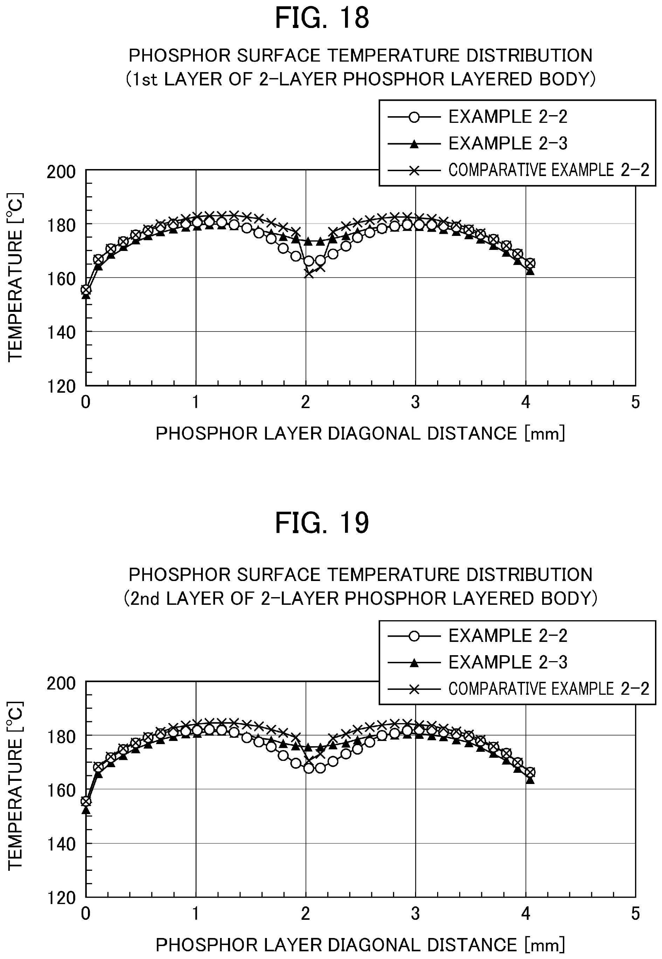

Fig. 18 illustrates the results of plotting temperatures along the diagonal of the first phosphor layers in the temperature distributions of Fig. 17. Specifically, Fig. 18 illustrates the relationship between the diagonal distance and the surface temperature of the first phosphor layer 20 along the dotted line in Fig. 17. Fig. 19 illustrates the results of plotting temperatures along the diagonal of the second phosphor layers in the temperature distributions of Fig. 17. Specifically, Fig. 19 illustrates the relationship between the diagonal distance and the surface temperature of the second phosphor layer 60 along the dotted line in Fig. 17.

As illustrated in Fig. 18, it can be seen that the surface temperature in the light emitting device of comparative example 2-2 is lower in the diagonal distance of 2 to 2.2 mm where the first phosphor layer is not present and the filling member is present, but is higher in other parts than that of the light emitting device of example 2-2. In particular, it can be seen that the surface temperature in the light emitting device of example 2-2 is significantly lower than that of the light emitting device of comparative example 2-2 in the diagonal distance range of 1 to 3 mm. It can also be seen that the surface temperature in the light emitting device of example 2-3 is also lower than that of the light emitting device of comparative example 2-2 in the diagonal distance range of 1 to 3 mm.

In addition, as illustrated in Fig. 19, it can be seen that surface temperature in the light emitting device of comparative example 2-2 is lower in the diagonal distance range of 2 to 2.2 mm where the second phosphor layer is not present and the filling member is present, but is higher as a whole than that of the light emitting device of example 2-2. In particular, it can be seen that the surface temperature in the light emitting device of example 2-2 is significantly lower than that of the light emitting device of comparative example 2-2 in the diagonal distance range of 1 to 3 mm. It can also be seen that the surface temperature in the light emitting device of example 2-2 is also lower than that of the light emitting device of comparative example 2-2 in the diagonal distance range of 1 to 3 mm.

As described above, the first phosphor layer and the second phosphor layer are each formed as a single plate-like member, and the first phosphor layer is arranged to be in contact with the multiple light emitting elements and the filling member, thereby generating heat conduction toward the region 23A and the filling member 30A where the amount of heat generation is small. As a result, it can be seen that heat dissipation from the first phosphor layer and the second phosphor layer is efficiently performed.

Furthermore, from the results of CAE analysis illustrated in Fig. 15, the average value of the decrease in the surface temperature of the first phosphor layer, and the maximum difference of the decrease in the surface temperature of the first phosphor layer were obtained in the light emitting device of example 2-1, and the light emitting devices of comparative example 2-1 and comparative example 2-3.

As listed in Table 3, in the diagonal distance ranges of 1.01 to 1.91 mm and 2.25 to 3.14 mm of the first phosphor layer, the light emitting device of example 2-1 exhibited an average decrease of 2.5 °C in the surface temperature of the first phosphor layer, compared with the light emitting device of comparative example 2-1. Furthermore, in the diagonal distance ranges of 1.01 to 1.91 mm and 2.25 to 3.14 mm, the light emitting device of example 2-1 exhibited an average decrease of 6.3 °C in the surface temperature of the first phosphor layer, compared with the light emitting device of comparative example 2-3.

Even in the entire diagonal distance range of 0.00 to 4.04 mm, the light emitting device of example 2-1 exhibited an average decrease of 1.1 °C compared with the light emitting device of comparative example 2-1, and the light emitting device of example 2-1 exhibited an average decrease of 7.2 °C compared with the light emitting device of comparative example 2-3. The maximum value of the surface temperature difference of the first phosphor layer between the light emitting device of example 2-1 and the light emitting device of comparative example 2-1 was 6.9 °C. The maximum value of the surface temperature difference between the first phosphor layer in the light emitting device of example 2-1 and the light emitting device of comparative example 2-3 was 26.2 °C.

It can be seen that by forming the first phosphor layer as a single plate-like member and arranging the first phosphor layer to be in contact with the multiple light emitting elements and the filling member, as described above, heat is efficiently dissipated from the entire first phosphor layer.

**[Table 3]**

| | Example 2-1 -comparative example 2-1 | Example 2-1 - comparative example 2-3 | Example 2-2 -comparative example 2-2 | | Example 2-3 -comparative example 2-2 | |
|---|---|---|---|---|---|---|
| Phosphor layer | GaSc | GaSc | GaSc | GGG | GaSc | GGG |
| Average value of decrease in temperature (°C) (diagonal distances 1.01 to 1.91mm, 2.25 to 3.14mm) | -2.5 | -6.3 | -4.5 | -4.7 | -3.3 | -3.5 |
| Average value of decrease in temperature (°C) (entire range of diagonal distance 0.00 to 4.04mm) | -1.1 | -7.2 | -2.3 | -2.8 | -2.2 | -2.8 |
| Maximum difference of temperature decrease (°C) | -6.9 | -26.2 | -8.6 | -9.6 | -3.7 | -3.8 |

From the results of the CAE analysis illustrated in Fig. 17, the average value of the decrease in the surface temperature of the first phoshop layer, and the maximum difference of the decrease in the surface temperature of the first phoshor layer were obtained in the light emitting device of example 2-2 and the light emitting device of comparative example 2-2. Similarly, the average value of the decrease in the surface temperature of the second phoshop layer, and the maximum difference of the decrease in the surface temperature of the second phosphor layer were also obtained.

As listed in Table 3, in the diagonal distance ranges of 1.01 to 1.91 mm and 2.25 to 3.14 mm of the first phosphor layer, the light emitting device of example 2-2 exhibited an average decrease of 4.5 °C in the surface temperature of the first phosphor layer, compared with the light emitting device of comparative example 2-2. In addition, in the entire diagonal distance range of 0.00 to 4.04 mm, the light emitting device of example 2-2 exhibited an average decrease of 2.3 °C compared with the light emitting device of comparative example 2-2. The maximum value of the surface temperature difference of the first phosphor layer between the light emitting device of example 2-2 and the light emitting device of comparative example 2-2 was 8.6 °C.

In the diagonal distance ranges of 1.01 to 1.91 mm and 2.25 to 3.14 mm of the second phosphor layer, the light emitting device of example 2-2 exhibited an average decrease of 4.7 °C in the surface temperature of the second phosphor layer, compared with the light emitting device of comparative example 2-2. In addition, in the entire diagonal distance range of 0.00 to 4.04 mm, the light emitting device of example 2-2 exhibited an average decrease of 2.8 °C compared with the light emitting device of comparative example 2-2. The maximum value of the surface temperature difference of the second phosphor layer between the light emitting device of example 2-2 and the light emitting device of comparative example 2-2 was 9.6 °C.

Furthermore, from the results of the CAE analysis illustrated in Fig. 17, the average value of the decrease in the surface temperature of the first phosphor layer, and the maximum difference of the decrease in the surface temperature of the first phosphor layer were obtained in the light emitting device of example 2-3 and the light emitting device of comparative example 2-2. Similarly, the average value of the decrease in the surface temperature of the second phosphor layer, and the maximum difference of the decrease in the surface temperature of the second phosphor layer were also determined.

As illustrated in Table 3, in the diagonal distance ranges of 1.01 to 1.91 mm and 2.25 to 3.14 mm of the first phosphor layer, the light emitting device of example 2-3 exhibited an average decrease of 3.3 °C in the surface temperature of the first phosphor layer, compared with the light emitting device of comparative example 2-2. Also in the entire diagonal distance range of 0.00 to 4.04 mm, the light emitting device of example 2-3 exhibited an average decrease of 2.2 °C compared with comparative example 2-2. The maximum value of the surface temperature difference of the first phosphor layer between the light emitting device of example 2-3 and the light emitting device of comparative example 2-2 was 3.7 °C.

In the diagonal distance ranges of 1.01 to 1.91 mm and 2.25 to 3.14 mm of the second phosphor layer, the light emitting device of example 2-3 exhibited an average decrease of 3.5 °C in the surface temperature of the second phosphor layer, compared with the light emitting device of comparative example 2-2. Also in the entire diagonal distance range of 0.00 to 4.04 mm, the light emitting device of example 2-3 exhibited an average decrease of 2.8 °C compared with the light emitting device of comparative example 2-2. The maximum value of the surface temperature difference of the second phosphor layer between the light emitting device of example 2-3 and the light emitting device of comparative example 2-2 was 3.8 °C.

It can be seen that by forming the first phosphor layer and the second phosphor layer as a single plate-like member, and arranging the first phosphor layer to be in contact with the multiple light emitting elements and the filling member, as described above, heat is efficiently dissipated from the entire first phosphor layer and the second phosphor layer.

Although the present embodiment has been described above, the present embodiment is not limited to these descriptions, and various modifications are possible within the scope of the gist of the present embodiment.

The entire contents of Japanese Patent Application No. 2023-185424 (application date: October 30, 2023) are incorporated herein by reference.

### INDUSTRIAL APPLICABILITY

In the present disclosure, it is possible to provide a light emitting device capable of efficiently performing heat dissipation from a phosphor layer.

### REFERENCE SIGNS LIST

- 1, 2, 3, 4: Light emitting device
- 10: Light emitting element
- 20: First phosphor layer
- 30, 30A: Filling member
- 60: Second phosphor layer
- 70: Third phosphor layer

## Claims

1. A light emitting device, comprising:
a plurality of light emitting elements arranged at a predetermined interval;
a first phosphor layer made from phosphor ceramic; and
a filling member that covers side surfaces of the plurality of light emitting elements and is provided between adjacent light emitting elements, wherein
the first phosphor layer is a single plate-like member that covers light output surfaces of the plurality of light emitting elements, and
the first phosphor layer is arranged to be in contact with the plurality of light emitting elements and the filling member.

2. The light emitting device according to claim 1, wherein
when a light output surface side of the plurality of light emitting elements is seen in plan view, outer dimensions of the first phosphor layer are substantially equal to outer dimensions of the plurality of light emitting elements.

3. The light emitting device according to claim 1 or 2, further comprising:
a second phosphor layer that is layered on the first phosphor layer.

4. The light emitting device according to claim 3, wherein
the second phosphor layer is made from a phosphor ceramic.

5. The light emitting device according to claim 3 or 4, wherein
when a light output surface side of the plurality of light emitting elements is seen in plan view, outer dimensions of the second phosphor layer are substantially equal to outer dimensions of the first phosphor layer.

6. The light emitting device according to any one of claims 3 to 5, wherein
the second phosphor layer is bonded to the first phosphor layer.

7. The light emitting device according to any one of claims 3 to 6, wherein
side surfaces of the first phosphor layer and side surfaces of the second phosphor layer are covered by the filling member.

8. The light emitting device according to any one of claims 1 to 7, wherein
the filling member includes a reflective material that reflects light.

9. The light emitting device according to any one of claims 3 to 7, further comprising:
one or more phosphor layers that is layered on the second phosphor layer.

10. The light emitting device according to any one of claims 3 to 7 and 9, further comprising:
a third phosphor layer that is layered on the second phosphor layer, wherein
the third phosphor layer includes phosphor particles and a resin for dispersing the phosphor particles.
